# FASCICULE DE BREVET EUROPEEN

(11) **EP 3 518 641 B1**
(45) Date de publication et mention de la délivrance du brevet: **13.10.2021**
(21) Numéro de dépôt: 19151167.4
(22) Date de dépôt: 10.01.2019
(51) Int. Cl.: H05K 7/20

(54) **SYSTÈME DE REFROIDISSEMENT D'UN DISPOSITIF ÉLECTRONIQUE ET MÉTHODE D'ASSEMBLAGE**
KÜHLSYSTEM EINER ELEKTRONISCHEN VORRICHTUNG, UND METHODE ZUM ZUSAMMENBAU
SYSTEM FOR COOLING AN ELECTRONIC DEVICE AND METHOD FOR ASSEMBLING SAME

(30) Priorité: 25.01.2018 FR 1850588
(43) Date de publication de la demande: 31.07.2019
(73) Titulaire: Aptiv Technologies Limited, St. Michael (BB)
(72) Inventeur: KORTA, Jakub, 31241 KRAKOW (PL); FRUEND, Marcel, 42859 REMSCHEID (DE); SKRUCH, Pawel, 32-031 Mogilany (PL)
(74) Mandataire: Vigand, Philippe

(56) Documents cités:
- EP-A1- 3 010 320
- EP-A2- 2 334 161
- CN-Y- 2 271 026
- DE-A1-102008 037 372
- US-A1- 2009 073 654

## Description

### DOMAINE TECHNIQUE

La présente invention concerne un système de refroidissement d'un dispositif électronique pour véhicule automobile et sa méthode d'assemblage avec le dispositif électronique.

### ARRIERE-PLAN TECHNOLOGIQUE DE L'INVENTION

Les dispositifs électroniques pour véhicule automobile comportent généralement des composants électroniques montés sur une carte à circuit imprimé. Certains composants électroniques sont des composants produisant de la chaleur. Il peut s'agir de microcontrôleurs dont la vitesse de traitement de données est telle que le microcontrôleur chauffe lors de ses opérations, ou encore par exemple, il peut s'agir de composants électroniques distribuant de forts courants électriques aux équipements du véhicule, ou encore simplement de pistes conductrices véhiculant de forts courants à travers la carte à circuit imprimé.

Afin de refroidir ces composants pour éviter leur défaillance, il est connu de dissiper leur chaleur en couplant directement thermiquement ces composants à un boîtier thermo conducteur du dispositif. Le boîtier est généralement équipé sur sa surface externe d'ailettes de refroidissement.

Lors d'un refroidissement actif des ailettes, il est fréquent d'utiliser plusieurs ventilateurs afin de pouvoir refroidir l'ensemble des ailettes. Les ailettes de refroidissement sont quant à elles soient venues de matière avec le boîtier, soient faisant partie d'un radiateur fixés par vissage ou collage par pâte thermique sur le boîtier. Un tel type de refroidissement présente une contrainte de poids importante et une efficacité thermique non optimum.

Le document DE 10 2008 037372 A1 décrit un boîtier pour composants électriques et/ou électroniques sensibles à la température qui permet d'avoir des températures différentes pendant le fonctionnement des composants à l'intérieur du boîtier, sans utiliser de composants électriques ou électromécaniques. Dans le boîtier, une première chambre de logement est séparée et isolée thermiquement d'une deuxième chambre de logement. Le boîtier présente des évidements dans une zone de la première chambre, disposés sur différentes parois latérales du boîtier.

Le document EP 2 334 161 A2 décrit un contrôleur ayant une carte de circuit imprimé disposée à l'intérieur d'un boîtier en plusieurs parties (12) et équipée d'un composant de puissance. Le boîtier est en contact thermique avec le composant pour la dissipation de la chaleur par le composant. Une interface thermiquement conductrice et couplable mécaniquement est disposée au niveau des zones latérales du boîtier. Un élément dissipateur thermique (par exemple soufflant) peut être couplé dans une position variable.

Il est donc important de proposer une solution nouvelle résolvant ces problèmes.

### RESUME DE L'INVENTION

Un dispositif électronique pour véhicule automobile comporte un boîtier thermiquement conducteur contenant une carte à circuit imprimé et un élément produisant de la chaleur monté sur la carte à circuit imprimé. Le boîtier comporte un fond de boîtier sur lequel est monté la carte à circuit imprimé et comporte un couvercle opposé au fond de boîtier. Le boîtier comporte également une pluralité d'ailettes de refroidissement s'étendant sur la surface extérieure du couvercle depuis une extrémité arrière de la pluralité d'ailettes jusqu'à une extrémité avant de la pluralité d'ailettes, la pluralité d'ailettes comprenant un premier groupe d'ailettes et un second groupe d'ailettes, chaque groupe d'ailettes s'étendant depuis l'extrémité arrière jusqu'à l'extrémité avant, l'extrémité arrière du premier groupe et l'extrémité avant du premier groupe définissant respectivement une entrée d'air du premier groupe et une sortie d'air du premier groupe, l'extrémité arrière du second groupe et l'extrémité avant du second groupe définissant respectivement une sortie d'air du second groupe et une entrée d'air du second groupe.

Des moyens prévus pour générer un flux d'air entre la pluralité d'ailettes du premier groupe sont agencés sur le boîtier, le flux d'air pouvant s'écouler depuis l'entrée d'air du premier groupe jusqu'à la sortie d'air du premier groupe de sorte à permettre un refroidissement de la pluralité d'ailettes du premier groupe. Le dispositif électronique comprend au moins un déflecteur d'air agencé en vis-à-vis de la sortie d'air du premier groupe et est configuré pour orienter le flux d'air vers l'entrée d'air du second groupe de sorte que le flux d'air puisse s'écouler entre les ailettes du second groupe depuis l'entrée d'air du second groupe jusqu'à la sortie d'air du second groupe afin de permettre un refroidissement des ailettes du second groupe.

Au moins un groupe d'ailettes peut être délimité de part et d'autre par deux parois verticales s'étendant sur la surface extérieure du couvercle et s'étendant le long dudit groupe d'ailettes depuis l'entrée d'air dudit groupe jusqu'à la sortie d'air dudit groupe, de sorte à pouvoir former ainsi un guide d'air prévu pour canaliser le flux d'air pouvant s'écouler entre les ailettes dudit groupe.

Le dispositif peut comprendre un capot de protection des ailettes comprenant une paroi supérieure agencée en appui sur le sommet de la pluralité d'ailettes du premier groupe et du second groupe.

La paroi supérieure peut être venue de matière avec le déflecteur d'air et avec les parois verticales.

La pluralité d'ailettes de refroidissement peut comprendre au moins une bande métallique pliée en accordéon, le pliage formant les ailettes s'étendant chacune transversalement à la bande et des espaces inter ailettes formant des zones de contact inter ailettes avec la surface extérieure du couvercle, la bande pouvant être agencée selon une première rangée d'ailettes de sorte que le flux d'air puisse circuler transversalement à la bande.

La pluralité d'ailettes peut comprendre une seconde rangée d'ailettes comportant une autre bande métallique pliée en accordéon formant des ailettes et des espaces inter ailettes, la seconde rangée d'ailettes étant agencée le long de la première rangée d'ailettes, les ailettes de la seconde rangée étant agencées en vis-à-vis des espaces inter ailettes de la première rangée.

Les zones de contact inter ailettes peuvent être fixées sur la surface extérieure du couvercle par brasage.

La paroi supérieure peut être une paroi métallique fixée sur le sommet de la pluralité d'ailettes du premier groupe et du second groupe par brasage.

Selon l'invention, une méthode d'assemblage du dispositif électronique comprend les étapes de :
plier au moins une bande métallique en accordéon de sorte à former des ailettes de refroidissement s'étendant chacune transversalement à la bande et des espaces inter ailettes formant des zones de contact inter ailettes ;
agencer les zones de contact inter ailettes de la bande métallique pliée sur le couvercle métallique du dispositif électronique;
fixer par brasage les zones de contact inter ailettes sur le couvercle métallique du dispositif électronique;
agencer sur le boîtier thermiquement conducteur du dispositif électronique des moyens prévus pour générer un flux d'air entre les ailettes d'un premier groupe d'ailettes de la bande métallique selon une première direction transversale à la bande;
agencer sur le boîtier thermiquement conducteur le déflecteur d'air de sorte à pouvoir orienter le flux d'air entre les ailettes d'un second groupe d'ailettes de la bande métallique selon une seconde direction transversale à la bande opposée à la première direction.

L'étape de fixer par brasage les zones de contact inter ailettes peut comprendre les étapes de :
disposer en appui sur le sommet des ailettes de la bande métallique la paroi supérieure d'un capot métallique comprenant au moins deux parois latérales opposées et agencées transversalement de part et d'autre de la bande par-dessus le couvercle;
exercer une force d'appui sur la paroi supérieure du capot métallique contre le sommet des ailettes générant un fléchissement des ailettes de sorte à maintenir les parois latérales du capot métallique sur la surface extérieure du couvercle;
fixer par brasage la paroi supérieure du capot métallique au sommet des ailettes en présence de la force d'appui;
fixer par brasage les parois latérales du capot métallique à la surface extérieure du couvercle en présence de la force d'appui;
fixer par brasage les zones de contact inter ailettes des bandes métalliques à la surface extérieure du couvercle en présence de la force d'appui.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue schématique de dessus d'un dispositif électronique pour véhicule automobile équipé d'un ventilateur générant un flux d'air entre des ailettes de refroidissement selon un premier mode de réalisation.
- La figure 2 est une vue schématique en perspective du dispositif électronique de la figure 1 comprenant un capot de protection des ailettes de refroidissement représenté en transparence.
- La figure 3 est une vue schématique de dessous en perspective du capot de protection de la figure 2.
- La figure 4 est une vue schématique en perspective d'une bande d'ailettes de refroidissement du dispositif électronique selon un premier mode de réalisation.
- La figure 5 est une vue schématique en coupe axial de l'agencement du capot de protection des ailettes de refroidissement avec les ailettes de refroidissement et avec le couvercle du dispositif électronique avant leur assemblage par brasage.
- La figure 6 est une vue schématique en coupe axial de l'agencement du capot de protection des ailettes de refroidissement avec les ailettes de refroidissement et le couvercle du dispositif électronique après leur assemblage par brasage.
- La figure 7 est un exemple d'organigramme d'une méthode d'assemblage du dispositif électronique selon l'invention.

### DESCRIPTION DES MODES DE REALISATION PREFERES

Afin de faciliter la description, et de façon non limitative, un repère orthogonal comprenant un axe longitudinal L, un axe transversal T et un axe vertical V est défini. Des orientations « bas », « haut », « dessus », « dessous », « inférieure » et « supérieure » sont définies selon la direction verticale. Des orientations « gauche », « droite » et « latérale » sont définies selon la direction transversale. Des orientations « arrière » et « avant » sont également définies selon la direction longitudinale.

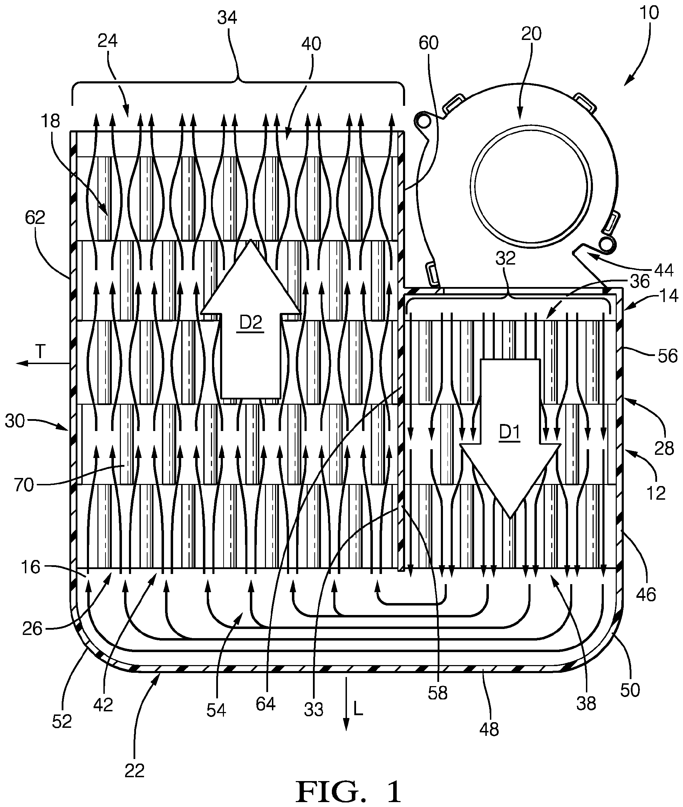

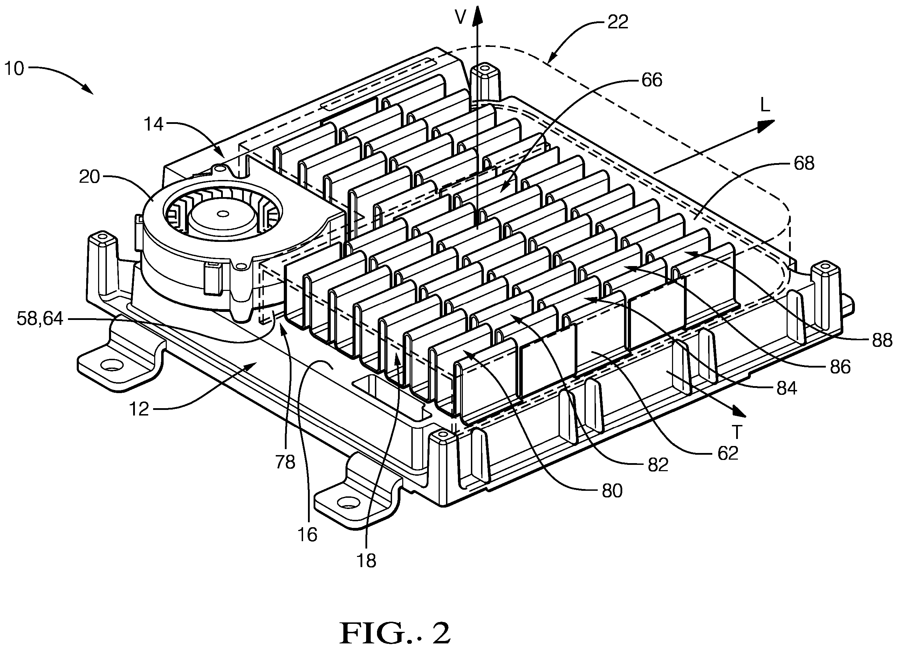

Selon la figure 1 et la figure 2, un dispositif électronique 10 pour véhicule automobile comprend un boîtier 12 thermiquement conducteur contenant une carte à circuit imprimé (non représentée) et un élément produisant de la chaleur (non représenté) monté sur la carte à circuit imprimé. Le boîtier 12 comporte un fond de boîtier sur lequel est monté la carte à circuit imprimé et un couvercle 14 opposé au fond de boîtier. Le couvercle 14 est équipé sur sa surface extérieure 16 d'une pluralité d'ailettes 18 de refroidissement, d'un ventilateur 20 et d'un déflecteur d'air 22.

La pluralité d'ailettes 18 s'étend selon l'axe longitudinal L sur la surface extérieure 16 du couvercle 14 depuis une extrémité arrière 24 jusqu'à une extrémité avant 26. La pluralité d'ailettes s'étend selon l'axe transversal T sur la surface extérieure 16 du couvercle 14 depuis une extrémité gauche 28 jusqu'à une extrémité droite 30. Selon le mode de réalisation représenté, l'extrémité arrière 24 de la pluralité d'ailettes 18 n'est pas une extrémité rectiligne, mais forme une bordure s'étendant transversalement en forme de marche ; l'extrémité avant 26 de la pluralité d'ailettes 18 forme une bordure rectiligne transversale.

La pluralité d'ailettes 18 comprend un premier groupe 32 d'ailettes 18 et un second groupe 34 d'ailettes 18 s'étendant longitudinalement depuis l'extrémité arrière 24 jusqu'à l'extrémité avant 26. Plus précisément, le premier groupe 32 d'ailettes 18 s'étend depuis la marche descendante de l'extrémité arrière 24 jusqu'à l'extrémité avant 26 de sorte à présenter une longueur selon l'axe longitudinal plus petite que le second groupe 34 d'ailettes 18.

Selon le mode de réalisation représenté, le premier groupe 32 d'ailettes 18 et le second groupe 34 d'ailettes 18 comprennent toutes les ailettes 18 de la pluralité d'ailettes 18, le premier groupe 32 d'ailettes 18 étant adjacent au second 34 groupe d'ailettes 18. En d'autres termes, le premier groupe 32 d'ailettes 18 est délimité du second groupe 34 d'ailettes 18 par une bordure commune 33.

L'extrémité arrière 24 relative au premier groupe 32 d'ailettes 18 sera dénommée extrémité arrière du premier groupe 32. L'extrémité arrière 24 relative au second groupe 34 d'ailettes 18 sera dénommée extrémité arrière 24 du second groupe 34. L'extrémité avant 26 relative au premier groupe 32 d'ailettes 18 sera dénommée extrémité avant du premier groupe 32. L'extrémité avant 26 relative au second groupe 34 d'ailettes 18 sera dénommée extrémité avant 26 du second groupe 34.

L'extrémité arrière 24 du premier groupe 32 définit une entrée d'air 36 du premier groupe 32 et l'extrémité avant 26 du premier groupe 32 définit une sortie d'air 38 du premier groupe 32. L'extrémité arrière 24 du second groupe 34 et l'extrémité avant 26 du second groupe 34 définissent respectivement une sortie d'air 40 du second groupe 34 et une entrée d'air 42 du second groupe 34.

L'extrémité arrière 34 en forme de marche descendante permet de dégager un premier espace 44 sur la surface extérieure 16 du couvercle 14 de sorte à pouvoir y agencer des moyens prévus pour générer un flux d'air 46 entre la pluralité d'ailettes 18 du premier groupe 32, tel par exemple le ventilateur 20 de préférence radial. Le ventilateur 20 est agencé de sorte à pouvoir générer le flux d'air 46 pouvant circuler directement entre la pluralité d'ailettes 18 du premier groupe 32 selon une première direction D1 depuis l'entrée d'air 36 du premier groupe 32 jusqu'à la sortie d'air 38 du premier groupe 32 de sorte à permettre un refroidissement des ailettes 18 du premier groupe 32.

Le déflecteur d'air 22 agencé en vis-à-vis de la sortie d'air 38 du premier groupe 32 est configuré pour orienter le flux d'air 46 vers l'entrée d'air 42 du second groupe 34 de sorte que le flux d'air 46 puisse s'écouler entre les ailettes 18 du second groupe 34 selon une seconde direction D2 depuis l'entrée d'air 42 du second groupe 34 jusqu'à la sortie d'air 40 du second groupe 34 afin de permettre un refroidissement des ailettes 18 du second groupe 34.

Plus précisément, le déflecteur d'air 22 comprend une paroi verticale 48 de déviation du flux d'air 46 agencée sur la surface extérieure 16 du couvercle 14 et s'étendant selon l'axe transversal T le long de la sortie d'air 38 du premier groupe 32 et le long de l'entrée d'air 42 du second groupe 34. La paroi vertical 48 de déviation du flux d'air 46 s'étend depuis son extrémité gauche 50 jusqu'à sa son extrémité droite 52, chacune desdites extrémité 50, 52 étant incurvée vers les ailettes 18 de refroidissement de sorte à pouvoir défléchir le flux d'air 46 de la sortie d'air 38 du premier groupe 32 d'ailettes 18 vers l'entrée d'air 42 du second groupe 34 d'ailettes 18.

De préférence, la paroi verticale 48 de déviation du flux d'air 46 du déflecteur d'air 22 comprend une portion rectiligne s'étendant selon l'axe transversal T depuis son extrémité gauche 50 courbée vers l'extrémité gauche 28 de la pluralité d'ailettes 18 jusqu'à son extrémité droite 52 courbée vers l'extrémité droite 30 de la pluralité d'ailettes 18. Le déflecteur d'air 22 longe donc entièrement la sortie d'air 38 du premier groupe 32 et l'entrée d'air 42 du second groupe 34. La paroi verticale 48 de déviation du flux d'air 46 du déflecteur d'air 22 est distante de l'extrémité avant 26 de la pluralité d'ailettes 18 de sorte à définir un second espace 54 sur la surface extérieure 16 du couvercle 14 permettant au flux d'air 46 de transiter depuis la sortie d'air 38 du premier groupe 32 d'ailettes 18 jusqu'à l'entrée d'air 42 du second groupe 34 d'ailettes 18.

L'invention ne se limite pas à une forme particulière de déflecteur d'air 22. La paroi verticale 48 de déviation du flux d'air 46 peut prendre différentes formes de sorte à pouvoir dévier le flux d'air d'une sortie d'air vers une entrée d'air.

Contrairement à l'art antérieur connu pour lequel des dispositifs électroniques peuvent être équipés de plusieurs ventilateurs afin de refroidir l'ensemble des ailettes de refroidissement, l'intégration du déflecteur d'air 22 sur le boîtier 12 permet de réduire le nombre de ventilateurs à un seul ventilateur 20 de taille adapté au dispositif électronique 10 pour véhicule automobile.

Afin de favoriser et de canaliser l'écoulement du flux d'air 46 pouvant circuler entre les ailettes 18 du premier groupe 32, deux premières parois 56, 58 verticales sont agencées longitudinalement de part et d'autre du premier groupe 32 d'ailettes 18. En d'autres termes, les deux premières parois 56, 58 verticales délimitent latéralement le premier groupe 32 d'ailettes 18. Chaque première paroi 56, 58 verticale s'étend tout le long du premier groupe 32 d'ailettes 18.

De même, afin de favoriser et de canaliser l'écoulement du flux d'air 46 entre les ailettes 18 du second groupe 34, deux secondes parois 60, 62 verticales sont agencées longitudinalement de part et d'autre du second groupe 34 d'ailettes 18. En d'autres termes, les deux secondes parois 60, 62 verticales délimitent latéralement le second groupe 34 d'ailettes 18. Chaque seconde paroi 60, 62 verticale s'étend tout le long du second groupe 34 d'ailettes 18. Selon le mode de réalisation représenté, la bordure commune 33 entre le premier groupe 32 d'ailettes 18 et le second groupe 34 d'ailettes 18 est matérialisée par une paroi verticale 64 commune aux deux premières parois 56, 58 verticales et aux deux seconde parois 60, 62 verticales. En d'autres termes, le dispositif électronique 10 représenté ne comprend que trois parois verticales 56, 62, 64 formant un guide d'air 31 pour les ailettes 18 du premier groupe 32 et formant un autre guide d'air 35 pour les ailettes 18 du second groupe 34.

De façon générale, afin de canaliser le flux d'air 46 pouvant s'écouler entre les ailettes 18 d'un groupe 32 le groupe d'ailettes 18 est délimité de part et d'autre par deux parois 56, 64 verticales s'étendant sur la surface extérieure 16 du couvercle 14 et s'étendant le long dudit groupe 32 d'ailettes 18 depuis l'entrée d'air 36 dudit groupe 32 jusqu'à la sortie d'air 38 dudit groupe 32 de sorte à former ainsi un guide d'air.

Selon la figure 2, le dispositif électronique 10 comporte un capot 66 de protection des ailettes 18 comprenant une paroi supérieure 68 agencée par-dessus le premier groupe 32 d'ailettes 18 et le second groupe 34 d'ailettes 18. Afin de visualiser les ailettes de refroidissement, le capot 66 de protection est représenté en transparence. Plus particulièrement, la paroi supérieure 68 est agencée en appui sur le sommet 70 des ailettes 18 de refroidissement du premier groupe 32 d'ailettes 18 et du second 34 groupe d'ailettes 18. Le capot 66 permet d'empêcher le dépôt de poussière ou autres impuretés entre les ailettes 18 qui pourraient réduire le refroidissement des ailettes 18 par le flux d'air 46.

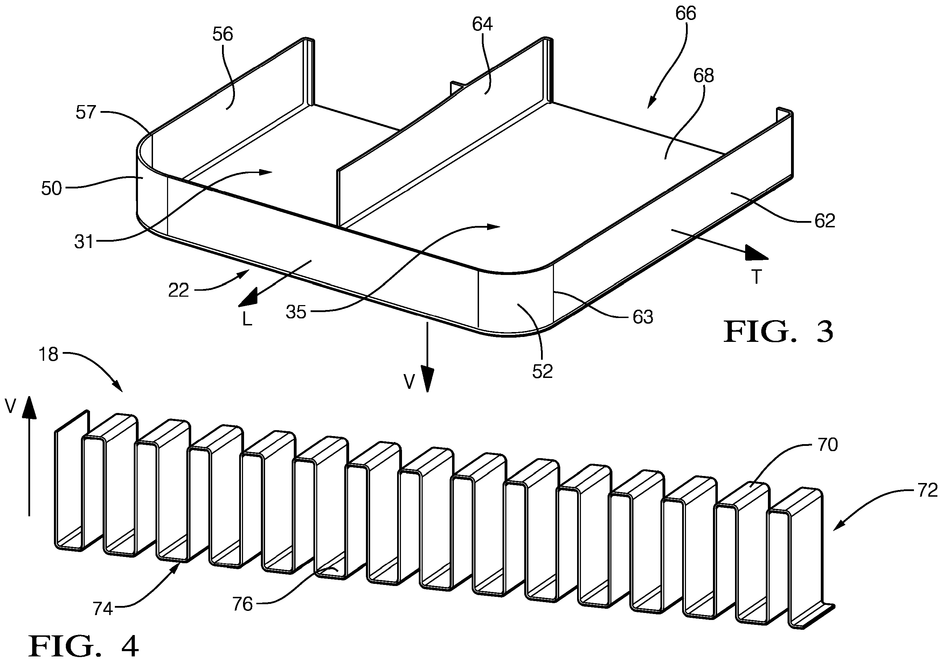

Selon la figure 2 et la figure 3, le capot 66 de protection des ailettes 18 comprend le déflecteur d'air 22 ainsi que les trois parois 56, 62, 64 verticales formant le guide d'air 31 du premier groupe 32 d'ailettes 18 et le guide d'air 35 du second groupe 34 d'ailettes 18. Plus précisément, la paroi supérieure 68 du capot 66 est venue de matière avec les trois parois 56, 62, 64 verticales formant les guides d'air 31, 35 et avec la paroi verticale 48 de déviation de flux d'air 46 du déflecteur d'air 22.

Les trois parois 56, 62, 64 verticales du capot 66 de protection sont formées par une paroi latérale gauche 56, une paroi latérale droite 62 et une paroi 64 verticale intérieure agencée parallèlement aux deux parois latérales 56, 62. Chacune des deux parois latérales 56, 62 s'étend selon l'axe longitudinal L depuis leur extrémité arrière jusqu'à leur extrémité avant de sorte à longer les extrémités droite 30 et gauche 28 de la pluralité d'ailettes 18. La paroi interne est la paroi verticale commune 64 séparant le premier groupe 32 d'ailettes 18 et le second groupe 34 d'ailettes 18.

L'extrémité avant 63 de la paroi 62 latérale droite et l'extrémité avant 57 de la paroi 56 latérale gauche sont respectivement agencées en continuité avec l'extrémité droite 52 courbée du déflecteur d'air 22 et avec l'extrémité gauche 50 courbée du déflecteur d'air 22.

Selon un mode de réalisation particulier, le capot 66 de protection des ailettes 18 est un capot 66 métallique de sorte à améliorer la dissipation thermique du dispositif électronique 10.

Selon la figure 4, une bande 72 d'ailettes 18 formant la pluralité d'ailettes 18 est représentée. La pluralité d'ailettes 18 de refroidissement est formée par des bandes 72 métalliques pliées en accordéon, le pliage formant des ailettes 18 de refroidissement s'étendant chacune transversalement à la bande, et des espaces inter ailettes 74 formant des zones de contact 76 inter ailettes prévues pour être agencées sur la surface extérieure 16 du couvercle 14 du dispositif électronique 10. Les ailettes 18 obtenues s'étirent généralement globalement verticalement de façon rectiligne.

De façon particulière, les bandes 72 métalliques sont découpées dans des tôles minces. Les ailettes 18 de refroidissement sont fabriquées à partir de couches minces (par exemple 0,3-0,5 mm) de "feuille de brasage d'aluminium" divisées en bandes 72 d'une largeur requise. Afin de former les ailettes 18 ou ailerons, chaque bande 72 d'aluminium est pliée mécaniquement à une forme et une hauteur désirées.

Une feuille de brasage d'aluminium est un type de matériau composite conçu pour améliorer le processus de brasage. Il s'agit d'un stratifié à trois couches constitué d'un matériau de noyau (par exemple, AA3003, pour lequel k = 180 W / (mK)) recouvert d'un ou deux côtés par (15) un Al-Si gaine à base (par exemple, alliage AA 4343, qui est Al-6,8-8,2% en poids de Si). Le stratifié est fabriqué par laminage à chaud et à froid, traité thermiquement en cas de besoin. L'alliage de gainage Al-Si fond et s'écoule à une température plus basse (577 ° C - 610 ° C) que l'alliage de base, assurant le refroidissement d'un joint brasé aux composants métalliques environnants.

De façon particulière, les bandes 72 d'ailettes 18 de refroidissement sont prévues pour être fixées par brasage sur la surface extérieure 16 du couvercle 14 du dispositif électronique 10.

L'assemblage des bandes 72 d'ailettes 18 sur le couvercle 14 en utilisant des joints brasés permet de résoudre le problème de la haute résistance thermique entre un boîtier électronique et la surface dissipatrice de chaleur (radiateur). La solution utilisant des joints brasés entre le couvercle 14 du boîtier 12 et les bandes 72 d'ailettes 18 permet d'augmenter la conductivité thermique entre le couvercle 14 et les ailettes 18, le matériau de brasage présentant une conductivité thermique supérieure d'un ou deux ordres de grandeur par rapport à un joint sec ou à un joint équipé d'un matériau d'interface thermique telle que communément utilisé dans l'art antérieur.

En utilisant cette technologie d'ailettes 18 de refroidissement, une même zone de dissipation thermique peut être obtenue avec des gains de poids significatifs en comparaison avec des ailettes 18 formées par moulage ou emboutissage du couvercle métallique du dispositif électronique 10. En outre, en augmentant le nombre de plis d'ailettes 18, la surface de dissipation thermique globale peut être beaucoup plus grande par rapport au radiateur de même dimension externe.

Selon la figure 2, les bandes 72 d'ailettes 18 sont agencées sur la surface extérieure 16 couvercle 14 du dispositif électronique 10 de sorte que le flux d'air 46 puisse circuler transversalement aux bandes 72. Les bandes 72 d'ailettes 18 s'étendent selon la direction de l'axe transversal T formant des rangées 80, 82, 84, 86, 88 d'ailettes 18 adjacentes les unes aux autres. De façon particulière, une rangée 84 d'ailettes 18 peut être formée de deux bandes 72 d'ailettes légèrement espacée l'une de l'autre de sorte à libérer une zone d'appui 78 de la paroi verticale commune 64 du capot 66 de protection sur la surface extérieure 16 du couvercle 14 du dispositif électronique 10.

Selon le mode de réalisation représenté à la figure 2, le couvercle 14 du dispositif électronique 10 comprend des rangées 84, 86, 88 d'ailettes 18 appartenant simultanément au premier groupe 32 d'ailettes 18 et au second groupe 34 d'ailettes 18 ainsi que d'autres rangées 80, 82 d'ailettes 18 appartenant uniquement au second groupe 34 d'ailettes 18. Les rangées 84, 86, 88 d'ailettes 18 appartenant simultanément au premier groupe 32 d'ailettes 18 et au second groupe 34 d'ailettes 18 s'étendent selon l'axe transversal T depuis l'extrémité droite 30 de la surface extérieure 16 du couvercle 14 jusqu'à l'extrémité gauche 28 de la surface extérieure 16 du couvercle 14. Les autres rangées 80, 82 d'ailettes 18 appartenant uniquement au second groupe 34 d'ailettes 18 s'étendent selon l'axe transversal T depuis l'extrémité droite 30 de la surface extérieure 16 du couvercle 14 jusqu'au premier espace 44 sur lequel est agencé le ventilateur 20 axial. De préférence, les rangées 84, 86, 88 d'ailettes 18 appartenant simultanément au premier groupe 32 d'ailettes 18 et au second groupe 34 d'ailettes 18 sont chacune formée par deux bandes 72 d'ailettes 18 légèrement espacées l'une de l'autre de sorte à libérer la zone d'appui 78 sur la surface extérieure 16 du couvercle 14 sur laquelle la paroi verticale commune 64 du capot 66 vient en butée afin de délimiter le guide d'air 31 du premier groupe 32 d'ailettes 18 et le guide d'air 35 du second groupe 34 d'ailettes 18.

De façon particulière et afin d'optimiser le refroidissement des ailettes, les rangées 80, 82, 84, 86, 88 d'ailettes 18 sont agencées les unes à la suite des autres de façon adjacente et de sorte que les ailettes 18 d'une rangée 82 soient agencées en vis-à-vis des espaces inter ailettes 74 de la rangée d'ailettes 84 leur étant directement adjacente. Ce décalage permet au flux d'air 46 de refroidir plus efficacement les ailettes 18 de chaque rangée 80, 82, 84, 86, 88.

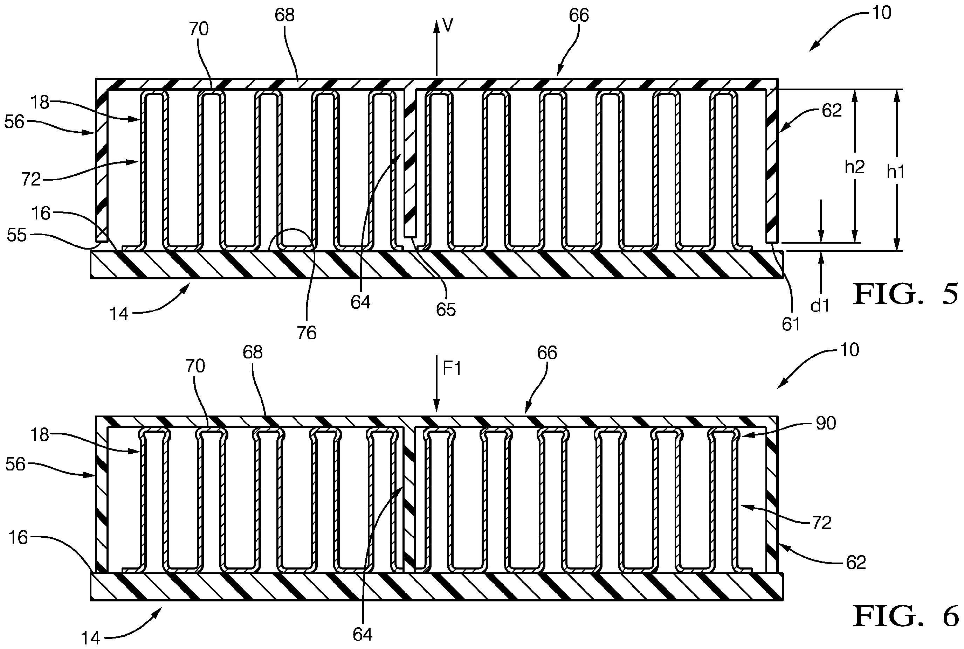

Selon la figure 5, les ailettes 18 de refroidissement et le capot 66 de protection des ailettes 18 sont représentées avant leur assemblage par brasage sur la surface extérieure 16 du couvercle 14 du dispositif électronique 10. Chaque bande 72 d'ailettes 18 est agencée sur la surface extérieure 16 du couvercle 14, plus particulièrement les zones de contact 76 inter ailettes sont disposées sur la surface extérieure 16 du couvercle 14 sans y être fixées. La paroi supérieure 68 du capot 66 de protection est en appui sur le sommet 70 des ailettes 18. La hauteur h1, selon l'axe vertical V, des ailettes 18 est légèrement plus grande que la hauteur h2, selon l'axe vertical V, des parois verticales 56, 62, 64 du capot 66 de sorte que l'extrémité basse 55, 61, 65 de chaque paroi verticale 56, 62, 64 n'est pas en contact avec la surface extérieure 16 du couvercle 14. A titre d'exemple non limitatif, cette différence de hauteur d1 peut être de l'ordre de quelques millimètres (mm), de préférence inférieure à 5 mm.

Selon la figure 6, les ailettes 18 de refroidissement et le capot 66 de protection des ailettes sont représentées assemblés par brasage sur la surface extérieure 16 du couvercle 14 du dispositif électronique 10. Plus particulièrement, la paroi supérieure 68 du capot 66 est fixée sur le sommet 70 des ailettes 18 par brasage. Durant l'étape de brasage du capot 66 de protection avec la surface extérieure 16 du couvercle 14 et des bandes d'ailettes 72 avec la surface extérieure 16 du couvercle 14, une force d'appui F1 est exercée sur la paroi supérieure 68 du capot 66 de protection en direction du couvercle 14 de sorte à mettre en contact les extrémités basses 55, 61, 65 des parois verticales 56, 62, 64 du capot 66 avec la surface extérieure 16 du couvercle 14. Cette méthode permet de s'affranchir des dispersions de hauteur h1 des ailettes 18 lors de l'assemblage du capot 66 sur le sommet 70 des ailettes 18 et sur la surface extérieure 16 du couvercle 14.

La force d'appui F1 sur la paroi supérieure 68 du capot 66 contre le sommet 70 des ailettes 18 produit un fléchissement des ailettes 18 de sorte à maintenir les parois verticales 56, 62, 64 du capot 66 sur la surface extérieure 16 du couvercle 14. Plus particulièrement, le fléchissement des ailettes 18 se traduit par une déformation du sommet 70 des ailettes 18. De façon particulière la déformation peut prendre la forme d'un bossage 90 protubérant vers l'extérieure des parois verticales des ailettes 18. D'autres types de déformations des ailettes 18 peuvent apparaitre selon la rigidité des ailettes 18 et selon la rigidité des zones de contact 76 inter-ailettes.

De préférence, l'assemblage du déflecteur d'air 22 sur la surface extérieure 16 du capot 14 s'opère de manière identique à l'assemblage des parois verticales 56, 62, 64 formant les guides d'air 31, 35.

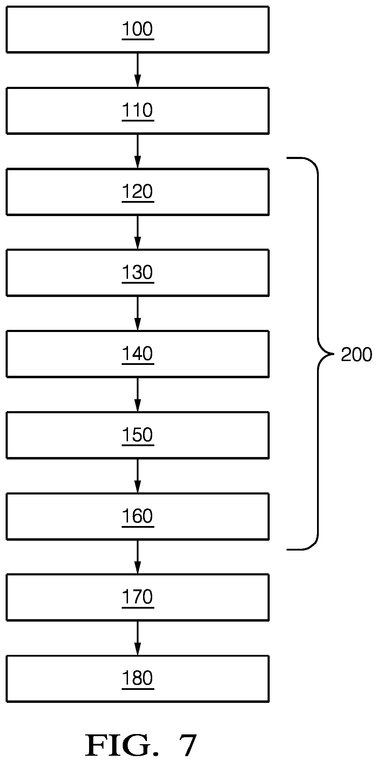

Selon la figure 7, une méthode d'assemblage du dispositif électronique 10 représenté à la figure 2 comprend plusieurs étapes. La méthode comporte une étape de pliage 100 en accordéon des bandes 72 métalliques de sorte à former des ailettes 18 de refroidissement s'étendant chacune transversalement aux bandes 72 et des espaces inter ailettes 74 formant des zones de contact 76 inter ailettes. Une étape ultérieure consiste à agencer 110 les zones de contact 76 inter ailettes des bandes 72 métalliques pliées sur la surface extérieure 16 du couvercle 14 métallique du dispositif électronique 10. De préférence, les bandes 72 métalliques sont agencées adjacentes entre elles et de sorte que le flux d'air 46 puisse circuler transversalement aux bandes 72. Une fois les bandes 72 métalliques pliées agencées sur le couvercle 14, une étape consiste à fixer 200 par brasage les zones de contact 76 inter ailettes sur le couvercle 14 métallique du dispositif électronique 10.

De préférence, l'étape consistant à fixer 200 par brasage les zones de contact 76 inter ailettes comprend une première étape consistant à disposer 120 en appui sur le sommet 70 des ailettes 18 de la bande 72 métallique, la paroi supérieure 68 du capot 66 métallique comprenant les parois verticales 56, 62, 64 agencées transversalement de part et d'autre des bandes 72. Une seconde étape consiste à exercer 130 une force d'appui F1 sur la paroi supérieure 68 du capot 66 contre le sommet 70 des ailettes 18 de sorte à maintenir les parois verticales 56, 62, 64 du capot 66 sur la surface extérieure 16 du couvercle 14. Cette seconde étape produit un fléchissement des ailettes 18. Une troisième étape consiste à fixer 140 par brasage la paroi supérieure 68 du capot 66 au sommet 70 des ailettes 18 en présence de la force d'appui F1, fixer 150 par brasage les parois verticales 56, 62, 64 du capot 66 à la surface extérieure 16 du couvercle 14 en présence de la force d'appui F1 et fixer 160 par brasage les zones de contact 76 inter ailettes des bandes 72 métalliques à la surface extérieure 16 du couvercle 14 en présence de la force d'appui F1.

Enfin, afin de pouvoir générer le flux d'air 46 entre les ailettes 18 du premier groupe 32 d'ailettes 18 et du second groupe 34 d'ailettes 18, une étape consiste à agencer 170 sur le boîtier 12 du dispositif électronique 10 les moyens prévus pour générer le flux d'air entre les ailettes 18 du premier groupe 32 d'ailettes 18 selon la première direction D1 transversale aux bandes d'ailettes 72 et une autre étape consiste à agencer 180 sur le boîtier 12 du dispositif électronique 10 le déflecteur d'air 22 de sorte à pouvoir orienter le flux d'air 46 entre les ailettes 18 du second groupe 34 d'ailettes 18 selon la seconde direction transversale D2 aux bandes d'ailettes 72, la dite seconde direction D2 étant opposée à la première direction D1.

## Revendications

1. Dispositif électronique (10) pour véhicule automobile comportant
un boîtier (12) thermiquement conducteur contenant une carte à circuit imprimé et un élément produisant de la chaleur monté sur la carte à circuit imprimé; le boîtier (12) comportant un fond de boîtier sur lequel est monté la carte à circuit imprimé et comportant un couvercle (14) opposé au fond de boîtier,
une pluralité d'ailettes (18) de refroidissement s'étendant sur la surface extérieure (16) du couvercle (14) depuis une extrémité arrière (24) de la pluralité d'ailettes (18) jusqu'à une extrémité avant (26) de la pluralité d'ailettes (18), la pluralité d'ailettes (18) comprenant un premier groupe (32) d'ailettes (18) et un second groupe (34) d'ailettes (18), chaque groupe (32, 34) d'ailettes (18) s'étendant depuis l'extrémité arrière (24) jusqu'à l'extrémité avant (26), l'extrémité arrière (24) du premier groupe (32) et l'extrémité avant (26) du premier groupe (32) définissant respectivement une entrée d'air (36) du premier groupe (32) et une sortie d'air (38) du premier groupe (32), l'extrémité arrière (24) du second groupe (34) et l'extrémité avant (26) du second groupe (34) définissant respectivement une sortie d'air (40) du second groupe et une entrée d'air (42) du second groupe (34),
des moyens (20) prévus pour générer un flux d'air (46) entre la pluralité d'ailettes (18) du premier groupe (32), le flux d'air (46) pouvant s'écouler depuis l'entrée d'air (36) du premier groupe (32) jusqu'à la sortie d'air (38) du premier groupe (32) de sorte à permettre un refroidissement de la pluralité d'ailettes (18) du premier groupe (32),
**caractérisé en ce que** le dispositif électronique (10) comprend au moins un déflecteur d'air (22) agencé en vis-à-vis de la sortie d'air (38) du premier groupe (32) et est configuré pour orienter le flux d'air (46) vers l'entrée d'air (42) du second groupe (34) de sorte que le flux d'air (46) puisse s'écouler entre les ailettes (18) du second groupe (34) depuis l'entrée d'air (42) du second groupe (34) jusqu'à la sortie d'air (40) du second groupe (34) afin de permettre un refroidissement des ailettes (18) du second groupe (34).

2. Dispositif (10) selon la revendication précédente **caractérisé en ce que** au moins un groupe (32) d'ailettes (18) est délimité de part et d'autre par deux parois (56, 64) verticales s'étendant sur la surface extérieure (16) du couvercle (14) et s'étendant le long dudit groupe (32) d'ailettes (18) depuis l'entrée d'air (36) dudit groupe (32) jusqu'à la sortie d'air (38) dudit groupe (32), de sorte à former ainsi un guide d'air (31) prévu pour canaliser le flux d'air (46) pouvant s'écouler entre les ailettes (18) dudit groupe (32).

3. Dispositif (10) selon l'une quelconque des revendications précédentes **caractérisé en ce qu'**il comprend un capot (66) de protection des ailettes (18) comprenant une paroi supérieure (68) agencée en appui sur le sommet (70) de la pluralité d'ailettes (18) du premier groupe (32) et du second groupe (34).

4. Dispositif (10) selon les revendications 1, 2 et 3 **caractérisé en ce que** la paroi supérieure (68) est venue de matière avec le déflecteur d'air (22) et avec les parois verticales (56, 64).

5. Dispositif (10) selon l'une quelconque des revendications précédentes **caractérisé en ce que** la pluralité d'ailettes (18) de refroidissement comprend au moins une bande métallique (72) pliée en accordéon, le pliage formant les ailettes (18) s'étendant chacune transversalement à la bande (72), et des espaces inter ailettes (74) formant des zones de contact (76) inter ailettes avec la surface extérieure (16) du couvercle (14), la bande (72) étant agencée selon une première rangée (84) d'ailettes (18) de sorte que le flux d'air (46) puisse circuler transversalement à la bande (72).

6. Dispositif (10) selon la revendication 5 **caractérisé en ce que** la pluralité d'ailettes (18) comprend une seconde rangée (86) d'ailettes (18) comportant une autre bande (72) métallique pliée en accordéon formant des ailettes (18) et des espaces inter ailettes (74), la seconde rangée (86) d'ailettes (18) étant agencée le long de la première rangée (84) d'ailettes, les ailettes (18) de la seconde rangée (86) étant agencées en vis-à-vis des espaces inter ailettes (74) de la première rangée (84).

7. Dispositif (10) selon l'une quelconque des revendications 5 et 6 **caractérisé en ce que** les zones de contact (76) inter ailettes sont fixées sur la surface extérieure (16) du couvercle (14) par brasage.

8. Dispositif (10) selon l'une quelconque des revendications précédentes prises en combinaison avec la revendication 3 **caractérisé en ce que** la paroi supérieure (68) est une paroi métallique fixée sur le sommet (70) de la pluralité d'ailettes (18) du premier groupe (32) et du second groupe (34) par brasage.

9. Méthode d'assemblage du dispositif électronique (10) de l'une quelconque des revendications précédentes comprenant les étapes de :
plier (100) au moins une bande métallique (72) en accordéon de sorte à former des ailettes (18) de refroidissement s'étendant chacune transversalement à la bande (72) et des espaces (74) inter ailettes formant des zones de contact (76) inter ailettes ;
agencer (110) les zones de contact (76) inter ailettes de la bande métallique (72) pliée sur le couvercle (14) métallique du dispositif électronique (10);
fixer (200) par brasage les zones de contact (76) inter ailettes sur le couvercle (14) métallique du dispositif électronique (10);
agencer (170) sur le boîtier (12) thermiquement conducteur du dispositif électronique (10) des moyens (20) prévus pour générer un flux d'air (46) entre les ailettes (18) d'un premier groupe (32) d'ailettes (18) de la bande (72) métallique selon une première direction (D1) transversale à la bande (72) ;
agencer (180) sur le boîtier (12) thermiquement conducteur le déflecteur d'air (22) de sorte à pouvoir orienter le flux d'air (46) entre les ailettes (18) d'un second groupe (34) d'ailettes (18) de la bande (72) métallique selon une seconde direction (D2) transversale à la bande (72) opposée à la première direction (D1).

10. Méthode d'assemblage selon la revendication précédente pour laquelle l'étape de fixer (200) par brasage les zones de contact (76) inter ailettes comprend les étapes de :
disposer (120) en appui sur le sommet (70) des ailettes (18) de la bande (72) métallique la paroi supérieure (68) d'un capot (66) métallique comprenant au moins deux parois latérales (56, 64) opposées et agencées transversalement de part et d'autre de la bande (72) par-dessus le couvercle (14);
exercer (130) une force d'appui (F1) sur la paroi supérieure (68) du capot (66) métallique contre le sommet (70) des ailettes (18) produisant un fléchissement des ailettes (18) de sorte à maintenir les parois latérales (56, 64) du capot (66) métallique sur la surface extérieure (16) du couvercle (14);
fixer (140) par brasage la paroi supérieure (68) du capot (66) métallique au sommet (70) des ailettes (18) en présence de la force d'appui (F1);
fixer (150) par brasage les parois latérales (56, 64) du capot (66) métallique à la surface extérieure (16) du couvercle (14) en présence de la force d'appui (F1);
fixer (160) par brasage les zones de contact (76) inter ailettes des bandes (72) métalliques à la surface extérieure (16) du couvercle (14) en présence de la force d'appui (F1).

## Patentansprüche

1. Elektronische Vorrichtung (10) für ein Kraftfahrzeug umfassend
ein wärmeleitendes Gehäuse (12), das eine Leiterplatte und ein auf die Leiterplatte montiertes wärmeerzeugendes Element enthält; wobei das Gehäuse (12) einen Gehäuseboden umfasst, auf den die Leiterplatte montiert ist, und einen dem Gehäuseboden gegenüberliegenden Deckel (14) aufweist,
eine Mehrzahl Kühlrippen (18), die sich auf der Außenfläche (16) des Deckels (14) von einem hinteren Ende (24) der Mehrzahl Rippen (18) zu einem vorderen Ende (26) der Mehrzahl Rippen (18) erstrecken, wobei die Mehrzahl Rippen (18) eine erste Gruppe (32) Rippen (18) und eine zweite Gruppe (34) Rippen (18) umfasst, wobei sich jede Gruppe (32, 34) Rippen (18) vom hinteren Ende (24) zum vorderen Ende (26) erstreckt, wobei das hintere Ende (24) der ersten Gruppe (32) und das vordere Ende (26) der ersten Gruppe (32) jeweils einen Lufteinlass (36) der ersten Gruppe (32) und einen Luftauslass (38) der ersten Gruppe (32) definieren, und das hintere Ende (24) der zweiten Gruppe (34) und das vordere Ende (26) der zweiten Gruppe (34) jeweils einen Luftauslass (40) der zweiten Gruppe und einen Lufteinlass (42) der zweiten Gruppe (34) definieren,
Mittel (20), die zum Erzeugen eines Luftstroms (46) zwischen der Mehrzahl Rippen (18) der ersten Gruppe (32) vorgesehen sind, wobei der Luftstrom (46) vom Lufteinlass (36) der ersten Gruppe (32) zum Luftauslass (38) der ersten Gruppe (32) strömen kann, um eine Kühlung der Mehrzahl Rippen (18) der ersten Gruppe (32) zu ermöglichen,
**dadurch gekennzeichnet, dass** die elektronische Vorrichtung (10) zumindest einen Luftabweiser (22) umfasst, der gegenüber dem Luftauslass (38) der ersten Gruppe (32) gestaltet ist, um den Luftstrom (46) zum Lufteinlass (42) der zweiten Gruppe (34) zu leiten, so dass der Luftstrom (46) zwischen den Rippen (18) der zweiten Gruppe (34) vom Lufteinlass (42) der zweiten Gruppe (34) zum Luftauslass (40) der zweiten Gruppe (34) strömen kann, damit eine Kühlung der Rippen (18) der zweiten Gruppe (34) ermöglicht wird.

2. Vorrichtung (10) nach vorstehendem Anspruch, **dadurch gekennzeichnet, dass** zumindest eine Gruppe (32) Rippen (18) auf beiden Seiten durch zwei senkrechte Wände (56, 64) begrenzt ist, die sich auf der Außenfläche (16) des Deckels (14) erstrecken und sich entlang der Gruppe (32) Rippen (18) vom Lufteinlass (36) der Gruppe (32) zum Luftauslass (38) der Gruppe (32) erstrecken, um damit eine Luftführung (31) zu bilden, die dazu vorgesehen ist, den Luftstrom (46) zu kanalisieren, der zwischen den Rippen (18) der Gruppe (32) strömen kann;

3. Vorrichtung (10) nach einem beliebigen der vorstehenden Ansprüche, **dadurch gekennzeichnet, dass** sie eine Abdeckung (66) zum Schutz der Rippen (18) umfasst, die eine obere Wand (68) aufweist, die anliegend auf der Oberseite (70) der Mehrzahl Rippen (18) der ersten Gruppe (32) und der zweiten Gruppe (34) gestaltet ist.

4. Vorrichtung (10) nach einem beliebigen der vorstehenden Ansprüche 1, 2 und 3, **dadurch gekennzeichnet, dass** die obere Wand (68) mit dem Luftabweiser (22) und mit den senkrechten Wänden (56, 64) einstückig ist.

5. Vorrichtung (10) nach einem beliebigen der vorstehenden Ansprüche, **dadurch gekennzeichnet, dass** die Mehrzahl Kühlrippen (18) zumindest einen wie ein Akkordeon gefalteten Metallstreifen (72) umfasst, wobei die Faltung die Rippen (18) bildet, die sich jeweils quer zu dem Streifen (72) erstrecken, und Rippenzwischenräume (74), die Rippenkontaktbereiche (76) mit der Außenfläche (16) des Deckels (14) bilden, wobei der Streifen (72) in einer ersten Reihe (84) Rippen (18) gestaltet ist, so dass der Luftstrom (46) quer zu dem Streifen (72) strömen kann.

6. Vorrichtung (10) nach Anspruch 5, **dadurch gekennzeichnet, dass** die Mehrzahl Rippen (18) eine zweite Reihe (86) Rippen (18) umfasst, die einen weiteren Metallstreifen (72) aufweist, der akkordeonartig gefaltet ist und Rippen (18) und Rippenzwischenräume (74) bildet, die zweite Reihe (86) Rippen (18) entlang der ersten Reihe (84) Rippen gestaltet ist, wobei die Rippen (18) der zweiten Reihe (86) gegenüber den Rippenzwischenräumen (74) der ersten Reihe (84) gestaltet sind.

7. Vorrichtung (10) nach einem beliebigen der vorstehenden Ansprüche 5 und 6, **dadurch gekennzeichnet, dass** die Rippenkontaktbereiche (76) auf der Außenfläche (16) der Abdeckung (14) durch Hartlöten befestigt sind.

8. Vorrichtung (10) nach einem beliebigen der vorstehenden Ansprüche in Kombination mit Anspruch 3, **dadurch gekennzeichnet, dass** die obere Wand (68) eine Metallwand ist, die an der Oberseite (70) der Mehrzahl Rippen (18) der ersten Gruppe (32) und der zweiten Gruppe (34) durch Hartlöten befestigt ist.

9. Verfahren zum Zusammenbau der elektronischen Vorrichtung (10) nach einem beliebigen der vorstehenden Ansprüche, das die folgenden Schritte umfasst:
Falten (100) zumindest eines Metallstreifens (72) wie ein Akkordeon, um Kühlrippen (18) zu bilden, die sich jeweils quer zu dem Streifen (72) erstrecken, und Rippenzwischenräume (74), Kontaktbereiche (76) zwischen den Rippen bilden;
Gestalten (110) der Kontaktbereiche (76) zwischen den Rippen des gefalteten Metallstreifens (72) auf der Metallabdeckung (14) der elektronischen Vorrichtung (10);
Befestigen (200) der Kontaktbereiche (76) zwischen den Rippen auf dem Metalldeckel (14) der elektronischen Vorrichtung (10) durch Hartlöten;
Gestalten (170) von Mitteln (20) auf dem wärmeleitenden Gehäuse (12) der elektronischen Vorrichtung (10), die zum Erzeugen eines Luftstroms (46) zwischen den Rippen (18) einer ersten Gruppe (32) Rippen (18) des Metallstreifens (72) in einer ersten Richtung (D1) quer zu dem Streifen (72) vorgesehen sind;
Gestalten (180) des Luftabweisers (22) auf dem wärmeleitenden Gehäuse (12), um den Luftstrom (46) zwischen den Rippen (18) einer zweiten Gruppe (34) Rippen (18) des Metallstreifens (72) in einer zweiten Richtung (D2) quer zu dem Streifen (72) entgegengesetzt zur ersten Richtung (D1) leiten zu können.

10. Verfahren zum Zusammenbau nach vorstehendem Anspruch, bei dem der Schritt mit der Befestigung (200) der Kontaktzonen (76) zwischen den Rippen durch Hartlöten die folgenden Schritte umfasst:
Anordnen (120) der oberen Wand (68) einer Metallabdeckung (66) umfassend zumindest zwei gegenüberliegende Seitenwände (56, 64), die quer auf beiden Seiten des Streifens (72) auf dem Deckel (14) angeordnet sind, die auf der Oberseite (70) der Flügel (18) des Metallstreifens (72) aufliegt;
Ausüben (130) einer Auflagekraft (F1) auf die obere Wand (68) der Metallabdeckung (66) gegen die Oberseite (70) der Rippen (18), was eine Biegung der Rippen (18) bewirkt, so dass die Seitenwände (56, 64) der Metallabdeckung (66) auf der Außenfläche (16) des Deckels (14) gehalten werden;
Befestigen (140) der oberen Wand (68) der Metallabdeckung (66) auf der Oberseite (70) der Rippen (18) durch Hartlöten bei anliegender Auflagekraft (F1);
Befestigen (150) der Seitenwände (56, 64) der Metallabdeckung (66) auf der Außenfläche (16) des Deckels (14) durch Hartlöten bei anliegender Auflagekraft (F1);
Befestigen (160) der Kontaktzonen (76) zwischen den Rippen der Metallstreifen (72) auf der Außenfläche (16) des Deckels (14) durch Hartlöten bei anliegender Auflagekraft (F1).

## Claims

1. An electronic device (10) for a motor vehicle including:
a thermally conductive casing (12) containing a printed circuit board and a heat-generating element mounted on the printed circuit board; the casing (12) including a casing bottom on which the printed circuit board is mounted and including a cover (14) opposite to the casing bottom,
a plurality of cooling fins (18) extending on the external surface (16) of the cover (14) from a rear end (24) of the plurality of fins (18) to a front end (26) of the plurality of fins (18), the plurality of fins (18) comprising a first group (32) of fins (18) and a second group (34) of fins (18), each group (32, 34) of fins (18) extending from the rear end (24) to the front end (26), the rear end (24) of the first group (32) and the front end (26) of the first group (32) defining respectively an air inlet (36) of the first group (32) and an air outlet (38) of the first group (32), the rear end (24) of the second group (34) and the front end (26) of the second group (34) defining respectively an air outlet (40) of the second group and an air inlet (42) of the second group (34),
means (20) provided to generate an air stream (46) between the plurality of fins (18) of the first group (32), the air stream (46) being able to flow from the air inlet (36) of the first group (32) to the air outlet (38) of the first group (32) so as to allow a cooling of the plurality of fins (18) of the first group (32),
**characterized in that** the electronic device (10) comprises at least one air deflector (22) arranged with respect to the air outlet (38) of the first group (32) and is configured to orient the air stream (46) to the air inlet (42) of the second group (34) so that the air stream (46) can flow between the fins (18) of the second group (34) from the air inlet (42) of the second group (34) to the air outlet (40) of the second group (34) in order to allow a cooling of the fins (18) of the second group (34) .

2. The device (10) according to the preceding claim **characterized in that** at least one group (32) of fins (18) is delimited on either side by two vertical walls (56, 64) extending over the external surface (16) of the cover (14) and extending along said group (32) of fins (18) from the air inlet (36) of said group (32) to the air outlet (38) of said group (32), so as to thus form an air guide (31) provided to channel the air stream (46) which can flow between the fins (18) of said group (32) .

3. The device (10) according to any one of the preceding claims **characterized in that** it comprises a lid (66) for protecting the fins (18) comprising an upper wall (68) arranged to bear on the top (70) of the plurality of fins (18) of the first group (32) and of the second group (34).

4. The device (10) according to claims 1, 2 and 3 **characterized in that** the upper wall (68) is integral with the air deflector (22) and with the vertical walls (56, 64).

5. The device (10) according to any one of the preceding claims **characterized in that** the plurality of cooling fins (18) comprises at least one metal strip (72) folded like an accordion, the folding forming the fins (18) each extending transversely to the strip (72), and inter-fin spaces (74) forming inter-fin contact areas (76) with the external surface (16) of the cover (14), the strip (72) being arranged according to a first row (84) of fins (18) so that the air stream (46) can circulate transversely to the strip (72).

6. The device (10) according to claim 5 **characterized in that** the plurality of fins (18) comprises a second row (86) of fins (18) including another metal strip (72) folded like an accordion forming fins (18) and inter-fin spaces (74), the second row (86) of fins (18) being arranged along the first row (84) of fins, the fins (18) of the second row (86) being arranged with respect to the inter-fin spaces (74) of the first row (84).

7. The device (10) according to any one of claims 5 and 6 **characterized in that** the inter-fin contact areas (76) are fixed on the external surface (16) of the cover (14) by brazing.

8. The device (10) according to any one of the preceding claims taken in combination with claim 3 **characterized in that** the upper wall (68) is a metal wall fixed to the top (70) of the plurality of fins (18) of the first group (32) and of the second group (34) by brazing.

9. A method for assembling the electronic device (10) of any one of the preceding claims comprising the steps of:
folding (100) at least one metal strip (72) like an accordion so as to form cooling fins (18) each extending transversely to the strip (72) and inter-fin spaces (74) forming inter-fin contact areas (76);
arranging (110) the inter-fin contact areas (76) of the metal strip (72) folded on the metal cover (14) of the electronic device (10);
fixing (200), by brazing, the inter-fin contact areas (76) on the metal cover (14) of the electronic device (10);
arranging (170) on the thermally conductive casing (12) of the electronic device (10) of the means (20) provided to generate an air stream (46) between the fins (18) of a first group (32) of fins (18) of the metal strip (72) along a first direction (D1) transverse to the strip (72);
arranging (180) on the thermally conductive casing (12) the air deflector (22) so as to be able to orient the air stream (46) between the fins (18) of a second group (34) of fins (18) of the metal strip (72) along a second direction (D2) transverse to the strip (72) opposite to the first direction (D1).

10. The assembly method according to the preceding claim for which the step of fixing (200) by brazing the inter-fin contact areas (76) comprises the steps of:
having (120), bearing on the top (70) of the fins (18) of the metal strip (72), the upper wall (68) of a metal lid (66) comprising at least two opposite side walls (56, 64) arranged transversely on either side of the strip (72) above the cover (14) ;
exerting (130) a bearing force (F1) on the upper wall (68) of the metal lid (66) against the top (70) of the fins (18) producing a bending of the fins (18) so as to maintain the side walls (56, 64) of the metal lid (66) on the external surface (16) of the cover (14);
fixing (140), by brazing, the upper wall (68) of the metal lid (66) to the top (70) of the fins (18) in the presence of the bearing force (F1);
fixing (150), by brazing, the side walls (56, 64) of the metal lid (66) to the external surface (16) of the cover (14) in the presence of the bearing force (F1);
fixing (160), by brazing, the inter-fin contact areas (76) of the metal strips (72) to the external surface (16) of the cover (14) in the presence of the bearing force (F1).
